# EUROPEAN PATENT APPLICATION

(11) **EP 3 905 318 A1**
(43) Date of publication of application: **03.11.2021**
(21) Application number: 20204393.1
(22) Date of filing: 28.10.2020
(51) Int. Cl.: H01L 23/367, H01L 23/473, H01L 25/00, H01L 23/467, H01L 23/44

(54) **POWER MODULE ASSEMBLY**

(30) Priority: 28.04.2020 KR 20200051608
(71) Applicant: LG Electronics Inc., Yeongdeungpo-gu Seoul 07336 (KR)
(72) Inventor: LEE, Gun, 08592 Seoul (KR); CHO, Seongmoo, 08592 Seoul (KR); KIM, Kwangsoo, 08592 Seoul (KR); CHOI, Siho, 08592 Seoul (KR)
(74) Representative: Vossius & Partner Patentanwälte Rechtsanwälte mbB

(57) **Abstract**

The present disclosure relates to a power module assembly, and may include a plurality of cooling fins on an upper cover covering an upper portion of a module housing and a lower cover covering a lower portion of the module housing to cool the power module received inside the module housing, and the plurality of cooling fins may constitute a cooling passage to allow coolant to flows into the module housing, and expand a heat exchange area of the power module, thereby improving the cooling performance of the power module.

## Description

### BACKGROUND

### 1. Technical Field

The present disclosure relates to a power module assembly capable of maximizing a heat dissipation effect.

### 2. Description of the Related Art

An eco-friendly vehicle powered by hydrogen or electricity includes a power conversion device such as an inverter. Furthermore, among the core components of the power conversion device, there is a power module assembly composed of a plurality of power modules.

For the power module assembly, technology for improving the performance of eco-friendly vehicles is being developed.

A power module provided in the power module assembly exhibits a high amount of heat around electronic devices during operation, and a rise in temperature of the power module directly affects the performance and durability of the power module.

Accordingly, the main technical development fields of the power module may include further improving the cooling performance of the power module.

US 2014/0327127 A1 (hereinafter, Patent Document 1) discloses a power module having a cooling structure.

In order to cool the power module, aluminum cooling fins formed in a ribbon shape may be bonded to a copper layer of a direct copper bonding (DCB) substrate by an ultrasonic bonding process.

Coolant flows along the cooling fins to cool heat generated by the copper layer of the power module.

However, the power module of Patent Document 1 has the following problems.

First, a bonding portion of the cooling fin may be corroded due to being in contact with coolant to weaken a bonding strength of the cooling fin.

Furthermore, the bonding strength of the cooling fin may be weakened due to the accumulation of fracture fatigue at a joint portion between the cooling fin and the copper layer to cause separation or peeling between the cooling fin and the copper layer, thereby reducing cooling performance.

Second, a bonding process for bonding the cooling fin to the power module and an inspection process thereof must be additionally carried out.

In addition, during the bonding process of the cooling fin, cracks may be caused in a ceramic layer of the DCB, resulting in unstable process and reduced reliability of components.

### SUMMARY

A first aspect of the present disclosure is to provide a power module assembly capable of maximizing cooling performance of a power module without bonding a cooling fin to the power module.

Furthermore, another aspect of the present disclosure is to provide a power module assembly capable of assembling a cooling structure without adding a bonding process of the cooling fin to the power module, thereby securing process stability and improving component reliability.

In order to solve such problems of the present disclosure so as to achieve the foregoing first object, a power module assembly according to the present disclosure may include a module housing having a power module for power conversion; an upper cover mounted to cover an upper portion of the module housing with the power module interposed therebetween; a lower cover mounted to cover a lower portion of the module housing with the power module interposed therebetween; and a plurality of first cooling fins protruding from an inner side of the upper cover toward one side surface of the power module to define a first cooling passage at an inner side of the upper cover.

The following examples refer to preferred embodiments:
According to an example associated with the present disclosure, the power module assembly may further include a plurality of second cooling fins protruding from an inner side of the lower cover toward the other side surface of the power module to define a second cooling passage at an inner side of the lower cover so as to dissipate heat in both direction from both side surfaces of the power module.

According to an example associated with the present disclosure, each of the plurality of first cooling fins and the plurality of second cooling fins may be in contact with the power module to expand a heat exchange area between coolant flowing into and/ or through the first cooling passage and the second cooling passage and the power module.

According to an example associated with the present disclosure, a protruding end portion of each of the plurality of first cooling fins and the plurality of second cooling fins may be defined in a flat shape.

According to an example associated with the present disclosure, each of the plurality of first cooling fins and the plurality of second cooling fins may be defined in a circular cross-sectional shape.

According to an example associated with the present disclosure, each of the plurality of first cooling fins and the plurality of second cooling fins may be defined to have a diameter gradually decreasing from an inner surface of each of the upper cover and the lower cover toward the power module.

According to an example associated with the present disclosure, a plurality of the power modules may be arranged in parallel on the same plane, and each of the plurality of first cooling fins and the plurality of second cooling fins may have the same protruding length.

According to an example associated with the present disclosure, a plurality of the power modules may be arranged to be spaced apart in a length direction in the module housing, and the plurality of first cooling fins and the plurality of second cooling fins may be arranged to be spaced apart in horizontal and vertical directions (a first (horizontal) and a second (vertical) direction, the first direction being orthogonal to the second direction), and the plurality of first cooling fins and the plurality of second cooling fins each may constitute a group to overlap with the power module in a top-down direction (a third direction, the third direction being orthogonal to the first direction and being orthogonal to the second direction), and a plurality of first cooling fin groups and a plurality of second cooling fin groups may be arranged with a distance larger than that between the plurality of first cooling fins or between the plurality of second cooling fins.

According to an example associated with the present disclosure, the plurality of first cooling fins or the plurality of second cooling fins may be arranged in a plurality of rows in horizontal and vertical directions (a first and a second direction, the first direction being orthogonal to the second direction), and among the plurality of rows, the cooling fins in odd rows and the cooling fins in even row may be alternately arranged to each other at equal intervals.

According to an example associated with the present disclosure, the power module may be received inside the module housing, and a heating surface of the power module may be exposed to the first cooling passage and the second cooling passage through an opening portion disposed to pass through the module housing in a top-down direction.

According to an example associated with the present disclosure, a plurality of the power modules may be received inside the module housing to be spaced apart, and the module housing may include a plurality of receiving portions arranged to pass therethrough in a top-down direction (third direction, the third direction being orthogonal to a first direction and being orthogonal to a second direction) to expose a heating surface of the power module, and arranged to pass therethrough in a lateral direction to protrude a plurality of terminals provided on both side surfaces of the power module, respectively, so as to receive each of the plurality of power modules; and a plurality of communication holes arranged to pass therethrough in a top-down direction to communicate between the first cooling passage and the second cooling passage.

According to an example associated with the present disclosure, the power module assembly may include a plurality of recess portions arranged to face each other on both side surfaces of the module housing, respectively, and defined to be concave along a circumference of the module housing; and a plurality of fastening protrusions arranged to protrude from an inner surface of each of the upper cover and the lower cover so as to be fitted to both sides of the recess portion, and spaced apart in a direction crossing both sidewalls of the recess portion with the plurality of first cooling fins interposed therebetween.

According to an example associated with the present disclosure, the power module assembly may include a coolant inlet port provided at one side of the upper cover, and disposed to communicate with the first cooling passage; and a coolant outlet port provided at the other side of the upper cover, and disposed to communicate with the first cooling passage.

According to an example associated with the present disclosure, the power module assembly may include a coolant inlet port provided at one side of the upper cover, and disposed to communicate with the first cooling passage; and a coolant outlet port provided at the other side of the lower cover, and disposed to communicate with the second cooling passage.

According to another example associated with the present disclosure, the power module assembly may include a plurality of coolant inlet ports provided at one side of the module housing, and arranged to communicate with one side of each of the first cooling passage and the second cooling passage; and a plurality of coolant outlet ports provided at the other side of the module housing, and arranged to communicate with the other side of each of the first cooling passage and the second cooling passage.

According to an example associated with the present disclosure, the first cooling fins and the second cooling fins may be formed to include aluminum or an aluminum alloy, and integrally formed on the upper cover and the lower cover, respectively.

The effects of the power module assembly according to the present disclosure will be described as follows.

First, a plurality of cooling fins may be disposed to protrude from inner surfaces of an upper cover and a lower cover respectively covering upper and lower portions of a module housing in which the power module is accommodated.

The plurality of cooling fins may define a plurality of cooling passages, thereby allowing coolant to flow through each of the upper cover and the lower cover. The power module may be in contact with coolant flowing along the cooling passages, thereby allowing heat generated from the power module to be transferred to the coolant. The power module may be cooled by coolant flowing along the cooling passages.

Second, the plurality of cooling fins may be formed of an aluminum or aluminum alloy material. The plurality of cooling fins may be respectively in contact with both sides of the power module. The cooling fins may have higher thermal conductivity than water, thereby allowing heat generated from the power module to be conducted to the plurality of cooling fins faster than coolant.

The plurality of cooling fins may expand a heat exchange area of the power module, thereby improving the cooling performance of the power module, and maximizing the cooling efficiency of the power module.

Third, the plurality of cooling fins may be made of the same metal material as the cover. Accordingly, the heat of the power module may be transferred to a cover through the cooling fins so as to be directly dissipated from the cover to an outer side of the module housing.

Fourth, the plurality of cooling fins may be integrally formed on each of the upper cover and the lower cover, and thus a separate bonding process may not be required. For example, aluminum cooling fins in the related art must be bonded to the power module, and the bonded cooling fins may be corroded by being in contact with coolant, thereby causing the separation/peeling of the cooling fins due to weakening of a bonding strength of the cooling fins. However, an integral structure of the cooling fins according to the present disclosure may solve the foregoing problems in the related art.

The plurality of cooling fins may be integrally formed on a cover of the power module assembly prior to manufacturing the cover, thereby simplifying an entire assembly process of the power module assembly. On the contrary, the structure of the cooling fins in the related art has a structure in which the cooling fins are ribbon-bonded to the power module, and thus an additional process and an inspection process may be required, thereby increasing the number of processes and complicating the manufacturing process.

Fifth, the plurality of cooling fins may be arranged to overlap with the power module in a top-down direction, and disposed at equal intervals in horizontal and vertical directions of the cover, thereby uniformly distributing the heat of the power module.

Sixth, the plurality of cooling fins may be arranged in a plurality of rows in horizontal and vertical directions in a cooling passage, and the cooling fins in odd rows and the cooling fins in even rows may be alternately arranged to each other, thereby allowing coolant that has passed through a passage between the cooling fines in odd rows to collide with the next cooling fins in even rows so as to improve heat transfer performance and heat exchange efficiency between the coolant and the cooling fins.

Seventh, the plurality of cooling fins may be defined in a circular cross-sectional shape. Accordingly, even though the flow of coolant flowing along the cooling passage collides with the plurality of cooling fins, the resistance of the cooling fins may be minimized.

Eighth, the plurality of cooling fins may be defined in a conical shape. One end of the cooling fin may be in contact with the power module in a flat shape, and the other end of the cooling fin may be integrally connected to the cover. The cooling fin may be defined to be inclined in a larger diameter from one end to the other end thereof. The inclined side structure of the cooling fins may increase a supporting force of the cover. In addition, as a contact area between the coolant and the cooling fin increases from one end of the cooling fin to the other end thereof, heat generated from the power module may move from one end of the cooling fin to the other end thereof to be in contact with the coolant in an extended area, thereby improving cooling efficiency.

Ninth, a structure of the plurality of cooling fins defining a cooling passage may be applied to the upper cover and the lower cover without concentrating on the power module, thereby maximizing the heat dissipation effect.

### BRIEF DESCRIPTION OF THE DRAWINGS

FIG. 1 is a perspective view showing a power module assembly according to the present disclosure.
FIG. 2 is an exploded view of the power module assembly in FIG. 1.
FIG. 3 is a conceptual exploded view showing a state in which a module housing and a power module are disassembled in FIG. 2.
FIG. 4 is a conceptual view showing a cross-section of the power module in FIG. 3.
FIG. 5 is a conceptual view showing a state in which cooling fins in FIG. 3 are in contact with the power module protruding from a lower cover.
FIG. 6 is a cross-sectional view showing a movement path of coolant in FIG. 1.
FIGS. 7A and 7B are a conceptual view showing a state in which a coolant inlet port and a coolant outlet port are disposed at different positions according to another embodiment of the present disclosure.
FIGS. 8A and 8B are a conceptual view showing a state in which a coolant inlet port and a coolant outlet port are disposed at different positions according to still another embodiment of the present disclosure.

### DETAILED DESCRIPTION OF THE EMBODIMENTS

Hereinafter, the embodiments disclosed herein will be described in detail with reference to the accompanying drawings, and the same or similar elements are designated with the same numeral references regardless of the numerals in the drawings and their redundant description will be omitted. A suffix "module" and "unit" used for constituent elements disclosed in the following description is merely intended for easy description of the specification, and the suffix itself does not give any special meaning or function. In describing an embodiment disclosed herein, moreover, the detailed description will be omitted when specific description for publicly known technologies to which the invention pertains is judged to obscure the gist of the present invention. Also, it should be understood that the accompanying drawings are merely illustrated to easily explain an embodiment disclosed herein, and therefore, they should not be construed to limit the technological concept disclosed herein by the accompanying drawings, and the concept of the present disclosure should be construed as being extended to all modifications, equivalents, and substitutes included in the concept and technological scope of the invention.

It will be understood that, although the terms first, second, etc. may be used herein to describe various elements, these elements should not be limited by these terms. The terms are used merely for the purpose to distinguish an element from the other element.

It will be understood that when an element is referred to as being "connected with" another element, the element can be directly connected with the other element or intervening elements may also be present. On the contrary, in case where an element is "directly connected" or "directly linked" to another element, it should be understood that any other element is not existed therebetween.

Singular expressions include plural expressions unless the context clearly indicates otherwise.

Terms "include" or "has" used herein should be understood that they are intended to indicate the existence of a feature, a number, a step, a constituent element, a component or a combination thereof disclosed in the specification, and it may also be understood that the existence or additional possibility of one or more other features, numbers, steps, constituent elements, components or combinations thereof are not excluded in advance.

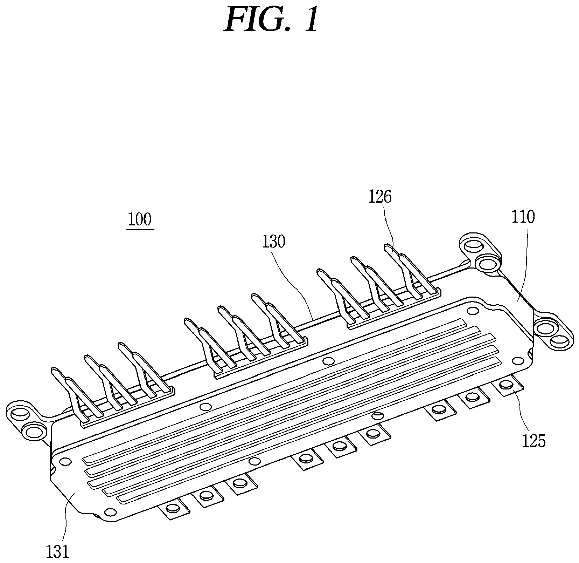

FIG. 1 is a perspective view showing a power module assembly 100 according to the present disclosure.

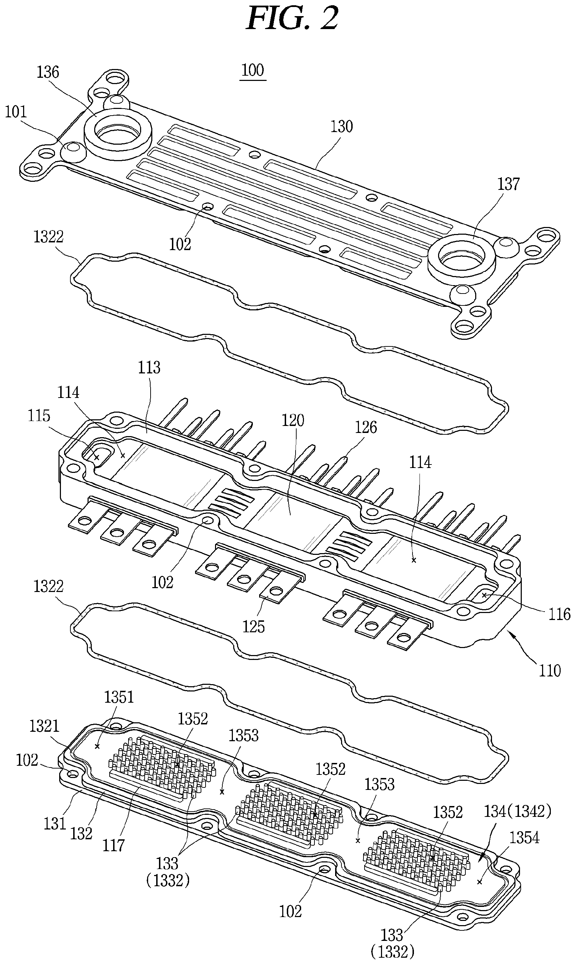

FIG. 2 is an exploded view of the power module assembly 100 in FIG. 1.

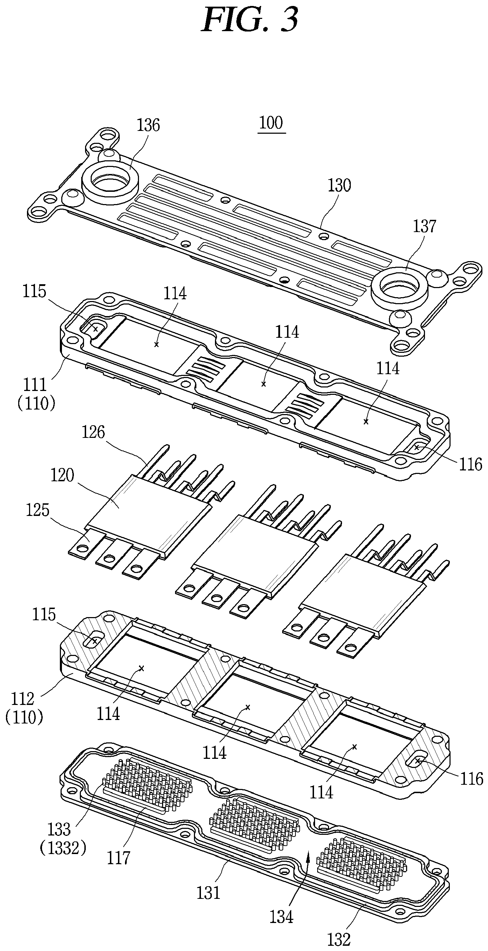

FIG. 3 is a conceptual exploded view showing a state in which a module housing 110 and a power module 120 are disassembled in FIG. 2.

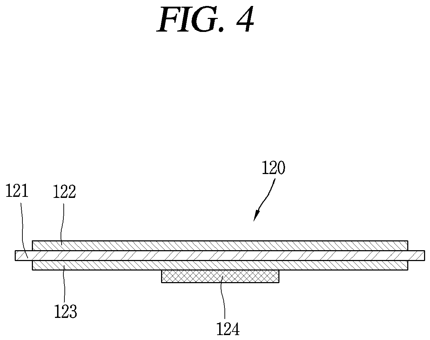

FIG. 4 is a conceptual view showing a cross-section of the power module 120 in FIG. 3.

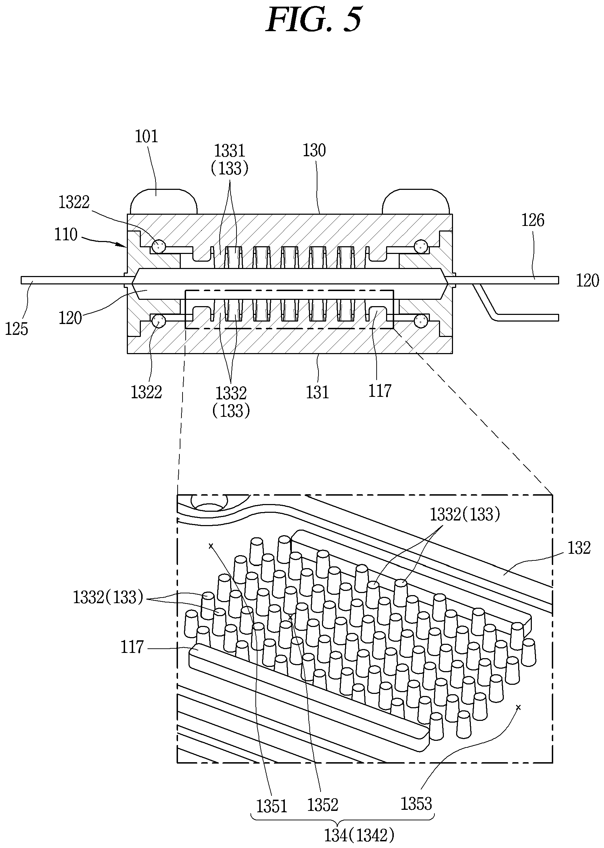

FIG. 5 is a conceptual view showing a state in which the cooling fins 133 in FIG. 3 are in contact with the power module 120 protruding from a lower cover 131.

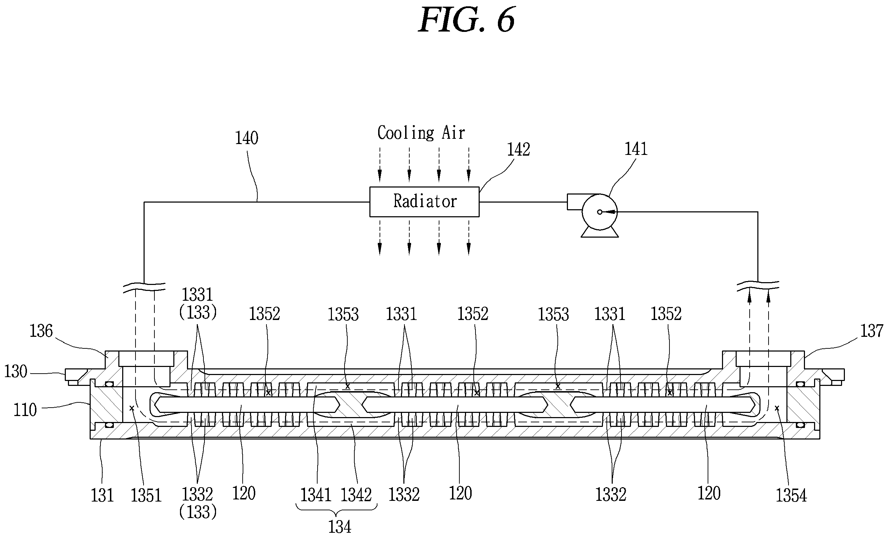

FIG. 6 is a cross-sectional view showing a movement path of coolant in FIG. 1.

The power module assembly 100 of the present disclosure may be one of core components constituting a power conversion device of an eco-friendly electric vehicle.

The power module assembly 100 of the present disclosure includes a module housing 110, an upper cover 130, and a lower cover 131.

The module housing 110 defines an appearance of the power module assembly 100 together with the upper cover 130 and the lower cover 131.

The module housing 110 may be defined in a rectangular shape having a vertical length that is larger than a horizontal length.

A height of the module housing 110 may be disposed to be shorter than the horizontal length and the vertical length of the module housing 110.

One or more power modules 120 may be provided inside the module housing 110.

In the present embodiment, it is shown that the plurality of power modules 120 have three power modules.

The power module 120 is configured to convert power. A plurality of first terminals 125 and a plurality of second terminals 126 may be arranged on one side and the other side of the power module 120, respectively.

The power module 120 may include a dielectric layer 121, a metal layer 122, 123, and an electronic device 124.

The dielectric layer 121 may include an insulating material. The dielectric layer 121 may include a ceramic material as an insulating material.

The metal layer 122, 123 may be formed of a metal, and may be bonded to at least one of both surfaces of the dielectric layer 121.

In the present embodiment, the metal layer may be composed of a first metal layer 122 and a second metal layer 123 bonded on both sides of the dielectric layer 121, respectively.

The first metal layer 122 and the second metal layer 123 may be formed of a copper material.

The electronic device 124 may be mounted on the metal layer 122, 123. The electronic device 124 is configured to implement a power conversion function of the power module 120. One or more electronic devices 124 may be provided on the metal layer. In the present embodiment, it is shown that one electronic device 124 is mounted on the metal layer.

A solder layer (not shown) made of solder between the electronic device 124 and the metal layer 122, 123 may be provided to electrically connect the electronic device 124 and the metal layer.

An electrical connection between the electronic device 124 and the metal layer, 122, 123 may be made using a method other than soldering.

The electronic device 124 may be implemented as a power semiconductor device.

The power semiconductor device may be composed of any one of, for example, an insulated gate transistor (IGBT), a bipolar, and a power MOSFET (Metal Oxide Silicon Field Effect Transistor).

Heat generated from the electronic device 124 may be dissipated through the metal layer.

At least part of the metal layer 122, 123 may be exposed to a cooling passage134 disposed to allow coolant to flow into the module housing 110.

Accordingly, part of the power module 120 may be cooled by the coolant.

The module housing 110 may include an upper housing 111 and a lower housing 112.

The upper housing 111 and the lower housing 112 are coupled to each other to surround the power module 120.

The upper housing 111 and the lower housing 112 may be formed into one body by insert injection molding with the power module 120 interposed therebetween.

The insert injection molding refers to a configuration that is inserted inside a mold, for example, a molding method in which a component such as the power module 120 is disposed at a predetermined position.

The mold may include a first mold corresponding to the upper housing 111 and a second mold corresponding to the lower housing 112.

According to this configuration, the upper housing 111 and the lower housing 112 may not only protect the power module 120 by wrapping, but also may eliminate the use of various fastening members for mechanical assembly between the upper housing 111 and the lower housing 112 and a sealing member for sealing the cooling passage 134 through which coolant flows.

Accordingly, the module housing 110 may eliminate the use of the fastening member 101 and the sealing member, thereby reducing an overall size of the power module assembly 100.

A plurality of receiving portions 114 are provided inside the module housing 110. The plurality of receiving portions 114 are configured to respectively receive a plurality of power modules 120.

The plurality of receiving portions 114 are arranged to be spaced apart from each other in a vertical direction of the module housing 110.

The receiving portion 114 is disposed in a horizontal direction of the module housing 110 so as to allow the terminals of the power module 120 to pass therethrough.

The receiving portion 114 is disposed to pass through the module housing 110 in a top-down direction to dissipate the heat of the power module 120.

The upper cover 130 is mounted on an upper portion of the module housing 110 to cover the upper portion of the module housing 110, that is, an upper side of the plurality of receiving portions 114.

The lower cover 131 is mounted on a lower portion of the module housing 110 to cover the lower portion of the module housing 110, that is, a lower side of the plurality of accommodating portions 114.

Each of the upper cover 130 and the lower cover 131 may be defined in a plate shape.

The upper cover 130 and the lower cover 131 are arranged to be spaced apart in a top-down direction with the module housing 110 interposed therebetween.

A plurality of cooling passages 134 may be arranged to allow coolant to flow into the module housing 110.

The plurality of cooling passages 134 may include a first cooling passage 1341 and a second cooling passage 1342.

The first cooling passage 1341 may be provided at an inner side of the upper cover 130.

The first cooling passage 1341 is formed to face an upper side of the receiving portion 114.

The second cooling passage 1342 may be provided at an inner side of the lower cover 131.

The second cooling passage 1342 is disposed to face a lower side of the receiving portion 114.

The first cooling passage 1341 and the second cooling passage 1342 may be elongated along the vertical directions of the upper cover 130 and the lower cover 131, respectively.

A coolant inlet port 136 and a coolant outlet port 137 may be disposed on the upper cover 130.

The coolant inlet port 136 may be disposed at one side of the upper cover 130. The coolant inlet port 136 may be disposed to protrude upward from the upper cover 130 in a circular tube shape.

The coolant outlet port 137 may be disposed at the other side of the upper cover 130. The coolant outlet port 137 may be disposed to protrude upward from the upper cover 130 in a circular tube shape.

The coolant inlet port 136 and the coolant outlet port 137 may be disposed at both ends of the upper cover 130, respectively, in a vertical direction.

The coolant inlet port 136 is disposed to communicate with one side of the first cooling passage 1341. The coolant outlet port 137 is disposed to communicate with the other side of the first cooling passage 1341.

Coolant may flow into the first cooling passage 1341 through the coolant inlet port 136. In addition, the coolant may flow out of the module housing 110 through the coolant outlet port 137 from the first cooling passage 1341.

A plurality of fastening holes 102 may be arranged at an edge of the module housing 110 to pass through the module housing 110 in a height direction thereof.

A plurality of fastening members 101 such as screws, etc. may be inserted and fastened through the fastening holes 102 arranged in the upper cover 130 and the lower cover 131, respectively, and the fastening holes 102 of the module housing 110 to fasten the cover 130 and the lower cover 131.

The module housing 110 may include recess portions 113. The recess portions 113 are provided at upper and lower sides of the module housing 110. The recess portions 113 may be defined to be concave along an edge of the module housing 110.

The recess portions113 are arranged at an inner side of the module housing 110 so as to bypass the plurality of fastening holes 102. The recess portions 113 are disposed at an outer side of the receiving portion 114.

A protruding portion 132 is provided on each of the upper cover 130 and the lower cover 131.

The protruding portion 132 is disposed to protrude in a thickness direction of the upper cover 130 or the lower cover 131. The protruding portion 132 is configured to be received in the recess portion 113.

The protruding portions 132 are disposed to be spaced from outer ends of the upper cover 130 and the lower cover 131, respectively, at a predetermined distance from each other.

The protruding portions 132 are disposed along the edges of the upper cover 130 and the lower cover 131, respectively. The protruding portion 132 may be defined in a closed loop shape.

A sealed groove 1321 may be disposed at an inner side of the protruding portion 132. The sealed groove 1321 may be disposed to have a very small width compared to its length.

A sealing ring 1322 is received in the sealed groove 1321. The sealing ring 1322 may be formed of a rubber material. The sealing ring 1322 is disposed to have a diameter equal to or slightly larger than a width of the sealed groove 1321, and configured to be coupled to the sealed groove 1321 by an interference fit.

The sealing ring 1322 seals between the module housing 110 and the upper cover 130 or between the module housing 110 and the lower cover 131, thereby preventing coolant from leaking into a gap therebetween.

The recess portion 113 and the protruding portion 132 are disposed to overlap with each other in a height direction or a top-down direction of the module housing 110. An edge portion of the module housing 110 is configured to surround an outer surface of the protruding portion 132.

An inner surface of the edge portion of the module housing 110 and an outer surface of the protruding portion 132 are configured to be in surface contact with each other.

According to this configuration, the edge portion of the module housing 110 and the protrusion portion 132 may be disposed in a structure overlapping with each other in an inward or outward direction, thereby effectively sealing a gap between the module housing 110 and the upper cover 130 and between the module housing 110 and the lower cover 131.

In addition, an overlapping structure between the edge portion of the module housing 110 and the protrusion portion 132 may define a gap between the module housing 110 and the cover to be curved in a top-down direction.

Accordingly, a movement distance of coolant moving from the cooling passage 134 disposed at an inner side of the module housing 110 to an outer side of the module housing 110.

One or a plurality of power modules 120 may be provided in the receiving portion 114 of the module housing 110. The plurality of power modules 120 may include a first power module 120 to an N-th power module 120. N may be a natural number above 2.

A plurality of communication holes are provided at an inner side of the module housing 110. The plurality of communication holes are configured to communicate between the first cooling passage 1341 and the second cooling passage 1342.

The plurality of communication holes may include a first communication hole 115 and a second communication hole 116.

The first communication hole 115 and the second communication hole 116 may be disposed between the recess portion 113 and the receiving portion 114.

The first communication hole 115 may be disposed adjacent to an inner side of one end portion of the recess portion 113.

The second communication hole 116 may be disposed adjacent to an inner side of the other end portion of the recess 113.

The first communication hole 115 may be disposed to pass through one side of the first cooling passage 1341 and one side of the second cooling passage 1342 in a top-down direction to be connected to each other. A first communication hole 115 may be disposed to communicate with the coolant inlet port 136.

The coolant may flow into one side of the first cooling passage 1341 through the coolant inlet port 136 or may flow into one side of the second cooling passage 1342 through the first communication hole 115.

Furthermore, coolant may be branched through the first communication hole 115 to flow into the first cooling passage 1341 and the second cooling passage 1342.

The second communication hole 116 may be disposed to pass through the other side of the first cooling passage 1341 and the other side of the second cooling passage 1342 in a top-down direction to connect to each other. The second communication hole 116 may be disposed to communicate with the coolant outlet port 137.

The coolant may be divided into two branches to move in one direction along the first cooling passage 1341 and the second cooling passage 1342, and then the coolant of the second cooling passage 1342 may be merged with the coolant of the first cooling passage 1341 while moving upward through the second communication hole 116, and discharged through the coolant outlet port 137.

Each of the upper cover 130 and the lower cover 131 includes a plurality of cooling fins 133.

The plurality of cooling fins 133 may include a plurality of first cooling fins 1331 and a plurality of second cooling fins 1332.

The plurality of first cooling fins 1331 are provided on an inner surface of the upper cover 130. The plurality of second cooling fins 1332 are provided on an inner surface of the lower cover 131.

The plurality of first cooling fins 1331 and the plurality of second cooling fins 1332 differ only in their formation positions, and have the same configuration and function as each other. The following description of the cooling fins 133 may be commonly applied to all of the first cooling fins 1331 and the second cooling fins 1332 unless otherwise distinguished.

The plurality of cooling fins 133 may be disposed to protrude toward the power module 120 from an inner surface of each of the upper cover 130 and the lower cover 131.

The plurality of cooling fins 133 may protrude higher in a top-down direction than a protruding length of the protruding portion 132 on an inner surface of each of the upper cover 130 and the lower cover 131.

The plurality of cooling fins 133 are arranged at an inner side of a closed loop of the protruding portion 132 to be spaced apart from each other. The protruding portion 132 may define an outermost boundary of the cooling passage 134.

The plurality of cooling fins 133 are configured to define a cooling passage 134.

The plurality of cooling fins 133 are configured to be in contact with coolant. The coolant may flow between the plurality of cooling fins 133.

One end of the cooling fins 133 is integrally formed on an inner surface of each of the upper cover 130 and the lower cover 131. The upper cover 130 and the lower cover 131 are integrally connected and supported.

The other end of the cooling fin 133 is configured to be in contact with the power module 120. The other end of the cooling fin 133 is defined in a flat shape.

Accordingly, heat generated by the power module 120 may be transferred to the plurality of cooling fins 133.

The plurality of cooling fins 133 may be formed of a metal material having a high heat transfer coefficient. For example, the plurality of cooling fins 133 may be formed of aluminum or an aluminum alloy.

According to this configuration, the plurality of cooling fins 133 may be formed of a metal material, thereby cooling the power module 120 more efficiently than simply being in contact with coolant with the power module 120.

For example, since aluminum has a thermal conductivity of 350 times greater than that of water, the heat of the power module 120 is transferred to the cooling fins 133 faster than the coolant.

The heat of the power module 120 may be transferred not only by being in contact with the coolant, but also by being in contact with the cooling fins 133.

The cooling fins 133 may expand a heat exchange area between the power module 120 and the coolant.

Each of the upper cover 130 and the lower cover 131 may be formed of aluminum or an aluminum alloy, which is the same material as the cooling fins 133.

Accordingly, the cooling fins 133 not only transfer the heat of the power module 120 to coolant by defining a passage of the coolant, but also expand the heat exchange area to transfer the heat of the power module 120 to the upper cover 130 and the lower cover 131, thereby dissipating heat into the atmosphere.

The cooling fins 133 may be defined in a circular shape to minimize a flow resistance of coolant.

Each of the plurality of cooling fins 133 may be disposed to protrude in a smaller diameter toward the power module 120 from an inner surface of each of the upper cover 130 and the lower cover 131.

The cooling fin 133 may be defined in a conical shape. An outer surface of the cooling fin 133 may be disposed to be inclined. The coolant may be in contact with an outer surface of the cooling fins 133.

According to this configuration, a cross-sectional area of one end of the cooling fin 133 supported by the cover may be larger than that of the other end of the cooling fin 133 in contact with the power module 120, thereby enhancing a supporting force of the cover with respect to the cooling fin 133.

Furthermore, as a contact area with coolant and a heat transfer area to the cover increase from one end of the cooling fin 133 to the other end of the cooling fin 133, thereby improving the heat transfer performance and efficiency of the cooling fin 133.

In addition, as a heat transfer direction of the cooling fin 133 goes from the transfer module to the cover, the heat transfer area increases.

Moreover, since a cross-sectional shape of the cooling fin 133 is circular, the heat transfer direction of the cooling fin 133 may be transferred in a radial direction.

The plurality of cooling fins 133 may constitute a group for each power module 120 and may be spaced apart at equal intervals. For example, the plurality of cooling fins 133 may be spaced at equal intervals in a range of 1 to 2 times their diameter.

A distance between the plurality of cooling fins 133 may be changed according to the size and area of the power module 120.

The plurality of cooling fins 133 may be spaced apart from each other in a first direction crossing both side surfaces of the protruding portion 132 having a larger length in a vertical direction and a second direction crossing both side surfaces of the protruding portion 132 having a smaller length in horizontal direction.

The plurality of cooling fins 133 may be spaced apart from the cooling passage 134 in a first row to an L-th row in the first direction (horizontal direction). L is a natural number above 2.

Alternatively, the plurality of cooling fins 133 may be spaced apart from the cooling passage 134 in a first row to an M-th row in the second direction (vertical direction). M is a natural number above 2. The first direction and the second direction may cross perpendicular to each other.

The plurality of cooling fins 133 may be spaced apart in L*M rows.

For the plurality of cooling fins 133, odd and even rows may be alternately arranged to each other in the first or the second direction.

According to a mutually staggered arrangement structure of the cooling fins 133, the cooling fins 133 in odd rows and the cooling fins 133 in even rows are arranged in a non-overlapping manner in the first direction or the second direction.

Furthermore, the cooling fins 133 in odd rows and the cooling fins 133 in even rows may be spaced apart to overlap with each other in a rectangular diagonal direction.

According to the arrangement structure of the cooling fins 133, when coolant flows along the first direction or the second direction in the cooling passage 134, the coolant may pass between two adjacent cooling fins 133 in odd rows and then collide with the cooling fins 133 in even rows, thereby more quickly and efficiently exchanging heat between the coolant and the cooling fins 133.

In addition, the cooling fins 133 in odd rows and the cooling fins 133 in even rows may be alternately arranged at equal intervals, and the plurality of cooling fins 133 may distribute heat evenly to the cooling passage 134.

The plurality of cooling fins 133 may constitute three groups corresponding to the number of power modules 120.

The plurality of cooling fins 133 may be intensively arranged on a metal plate that is a heating portion of the power module 120.

The plurality of cooling fins 133 are disposed to overlap with the power module 120 in a thickness direction or a top-down direction.

Relatively less heat may be generated in a space between the power modules 120.

The plurality of cooling fins 133 may not be disposed in a space between the power modules 120.

The first cooling fin 1331 disposed in the first cooling passage 1341 and the second cooling fin 1332 disposed in the second cooling passage 1342 may be arranged in a vertically symmetrical manner around the power module 120.

Furthermore, the plurality of cooling fins 133 may be arranged in a horizontally symmetrical manner in a vertical direction of the cooling passage 134.

A plurality of fastening protrusions 117 may be provided at an inner side of each of the upper cover 130 and the lower cover 131.

The fastening protrusions 117 are configured to fasten the upper cover 130 and the lower cover 131 to upper and lower sides of the module housing 110.

The plurality of fastening protrusions 117 may have a small width to be elongated in a vertical direction of the cover.

The plurality of fastening protrusions 117 may be disposed to protrude in a top-down direction toward the power module 120 from an inner surface of each of the upper cover 130 and the lower cover 131.

The fastening protrusion 117 may protrude higher than a protruding length of the protruding portion 132 and lower than a protruding length of the cooling fin 133.

The plurality of fastening protrusions 117 may be arranged to be spaced apart in a horizontal direction at an inner side of the protruding portion 132.

The plurality of fastening protrusions 117 may be arranged to be spaced apart on both sides in a horizontal direction of the group of cooling fins 133 with one group of cooling fins 133 interposed therebetween.

The plurality of fastening protrusions 117 may be disposed in parallel for each pair for each group of cooling fins 133.

Each of the plurality of fastening protrusions 117 may extend to correspond to a vertical length of one group of cooling fins 133.

The plurality of fastening protrusions 117 may not be arranged in a space between the plurality of groups of cooling fins 133.

Since the plurality of fastening protrusions 117 are inserted into and coupled to the receiving portion 114, the upper cover 130 or the lower cover 131 may be fastened to upper and lower sides of the module housing 110, respectively.

Each of the first cooling passage 1341 and the second cooling passage 1342 may be composed of an inlet region 1351, a plurality of main heat transfer regions 1352, a plurality of intermediate header regions 1353, and an outlet region 1354. have.

Based on a flow direction of the coolant, each of the first cooling passage 1341 and the second cooling passage 1342 may be arranged in the order of the inlet region 1351, the main heat transfer region 1352, the intermediate header region 1353, the main heat transfer region 1352, the intermediate header region 1353, the main heat transfer region 1352, and the outlet region 1354.

The plurality of cooling fins 133 may be arranged only in the main heat transfer region 1352.

The inlet region 1351 is a region disposed adjacent to the coolant inlet port 136 and connected to communicate with the coolant inlet port 136.

The cooling fins 133 are arranged in the main heat transfer region 1352. In the main heat transfer region 1352, the heat of the power module 120 may be intensively dissipated through the plurality of cooling fins 133.

The intermediate header region 1353 is disposed between the plurality of main heat transfer regions 1352. Although the cooling fins 133 are not disposed in the intermediate header region 1353, coolant exiting from the main heat transfer region 1352 merges in the intermediate header region 1353, thereby uniformly mixing coolants with different temperatures due to different heat exchange amounts for each region of the power module 120.

In addition, the intermediate header region 1353 may distribute uniformly mixed coolant to a passage between the cooling fins 133 of the main heat transfer region 1352.

The outlet region 1354 is a region disposed adjacent to the coolant outlet port 137 and connected to communicate with the coolant outlet port 137.

The coolant inlet port 136 and the coolant outlet port 137 may be connected to a radiator 142 of a vehicle through a coolant circulation line 140.

A coolant circulation pump 141 may be provided in the coolant circulation line 140.

The coolant circulation pump 141 may provide power to coolant to circulate the coolant.

The radiator 142 may exchange heat with coolant received from the power module assembly 100 with outside air, thereby cooling the high-temperature coolant and then transferring the cooled coolant to the power module assembly 100 again.

Looking at a circulation path of coolant, the coolant flows to the coolant inlet port 136 → the first cooling passage 1341 / the second cooling passage 1342 (cooling of the power module 120) → the coolant outlet port 137 at an inside of the power module assembly 100, and flows to the circulation line 140 → the radiator 142 (cooling of the coolant) → the circulation line 140 at an outside of the power module assembly 100, and circulates to the power module assembly 100 again.

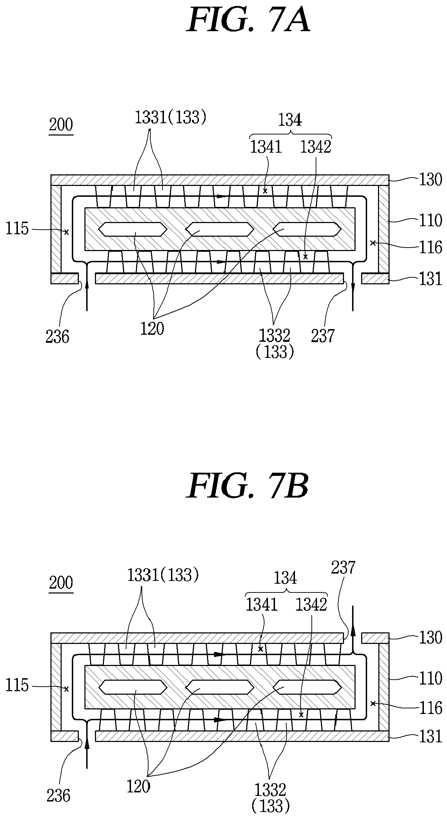

FIGS. 7A and 7B are a conceptual view showing a state in which a coolant inlet port 236 and a coolant outlet port 237 are disposed at different positions according to another embodiment of the present disclosure.

An embodiment shown in FIG. 7A differs from the embodiments of FIGS. 1 through 6 in that the coolant inlet port 236 and the coolant outlet port 237 are provided at both end portions of the lower cover 131, respectively.

Part of coolant introduced through the coolant inlet port 236 flows into the inlet region 1351 of the second cooling passage 1342, and another part of the coolant is branched through the first communication hole 115 to flow into the inlet region 1351 of the first cooling passage 1341.

The coolant flows along the first cooling passage 1341 and the second cooling passage 1342, respectively, to absorb heat from both surfaces of the plurality of power modules 120 arranged in series.

Then, coolant flowing out of the outlet region 1354 of the first cooling passage 1341 merges with coolant flowing out of the outlet region 1354 of the second cooling passage 1342 through the second communication hole 116.

Subsequently, the merged coolant flows out through the coolant outlet port 237, moves to the radiator 142 to be cooled, and then flows back into the coolant inlet port 236.

Other components are the same or similar to those of the foregoing embodiments of FIGS. 1 through 6, and thus redundant descriptions thereof will be omitted.

An embodiment shown in FIG. 7B differs from the embodiments of FIGS. 1 through 6 or the embodiment of FIG. 7A in that the coolant inlet port 236 is disposed at one side of the lower cover 131, and the coolant outlet port 237 is disposed at the other side of the upper cover 130.

Other components are the same as or similar to those of the foregoing embodiments of FIGS. 1 through 6 or the embodiment of FIG. 7A, and thus redundant descriptions thereof will be omitted.

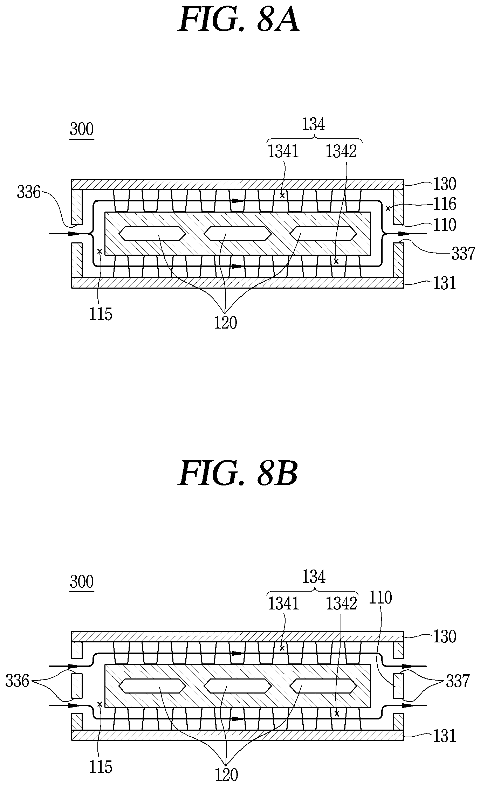

FIGS. 8A and 8B are a conceptual view showing a state in which a coolant inlet port 336 and a coolant outlet port 337 are disposed at different positions according to still another embodiment of the present disclosure.

An embodiment shown in FIG. 8A differs from the embodiments of FIGS. 1 through 6 in that the coolant inlet port 336 and the coolant outlet port 337 are provided in the module housing 110.

One coolant inlet port 336 may be disposed at one side of the module housing 110.

One coolant outlet port 337 may be disposed at the other side of the module housing 110.

The coolant inlet port 336 and the coolant outlet port 337 may be disposed on side surfaces of the module housing 110 in opposite directions, respectively.

The coolant inlet port 336 may be disposed on a front end surface of the module housing 110 in a vertical direction. The coolant inlet port 336 may be disposed to communicate with the first communication hole 115.

The first communication hole 115 is disposed to be branched in a top-down direction from the coolant inlet port 336, and configured to connect one side of the first cooling passage 1341 and one side of the second cooling passage 1342.

Coolant may flow into the coolant inlet port 336, and is branched in both directions from the first communication hole 115 to flow into the first cooling passage 1341 and the second cooling passage 1342, respectively.

The coolant outlet port 337 may be disposed on a rear end surface of the module housing 110 in a vertical direction. The coolant outlet port 337 may be disposed to communicate with the second communication hole 116.

The second communication hole 116 is disposed to merge in a top-down direction in the outlet region 1354 of the first and second cooling passages 1341, 1342, and configured to connect the other side of the first cooling passage 1341 and the other side of the second cooling passage 1342.

Coolant may flow out of the outlet region 1354 of the first cooling passage 1341 and the outlet region 1354 of the second cooling passage 1342, respectively, and merge in the second communication hole 116 to be discharged through the coolant outlet port 337 to an outside of the module housing 110.

In an embodiment shown in FIG. 8B, a plurality of coolant inlet ports 336 and a plurality of coolant outlet ports 337 are arranged in a plurality of rows on front and rear end surfaces of the module housing 110, respectively.

The plurality of coolant inlet ports 336 and the plurality of coolant outlet ports 337 may be arranged to be spaced apart in a top-down direction of the module housing 110.

The plurality of coolant inlet ports 336 may include a first coolant inlet port 336 and a second coolant inlet port 336.

The first coolant inlet port 336 may be disposed to communicate with one side of the first cooling passage 1341.

The second coolant inlet port 336 may be disposed to communicate with one side of the second cooling passage 1342.

The plurality of coolant outlets 337 may include a first coolant outlet port 337 and a second coolant outlet port 337.

The first coolant outlet port 337 may be disposed to communicate with one side of the first cooling passage 1341.

The second coolant outlet port 337 may be disposed to communicate with the other side of the second cooling passage 1342.

Each of the plurality of coolant inlet ports 336 and the plurality of coolant outlet ports 337 may correspond to the plurality of cooling passages 134 on a one-to-one basis and may be connected in parallel.

According to this configuration, a movement path of coolant that connects between the plurality of coolant inlet ports 336 and the inlet regions 1351 of the plurality of cooling passages 134, respectively, may be disposed at the shortest distance, thereby minimizing a flow resistance of fluid at a section without the cooling fins 133.

Furthermore, a movement path of coolant that connects between the outlet regions 1354 of the plurality of cooling passages 134 and the plurality of coolant outlet ports 337, respectively, may be disposed at the shortest distance, thereby minimizing a flow resistance of fluid at a section without the cooling fins 133.

Other components are the same or similar to those of the foregoing embodiments of FIGS. 1 through 6, and thus redundant descriptions thereof will be omitted.

Accordingly, according to the present disclosure, a plurality of cooling fins 133 are disposed to protrude from inner surfaces of the upper cover 130 and the lower cover 131, respectively, covering upper and lower portions of the module housing 110 in which the power module 120 is received.

The plurality of cooling fins 133 may constitute a plurality of cooling passages 134 to allow coolant to flow through each of the upper cover 130 and the lower cover 131. The power module 120 may be in contact with coolant flowing along the cooling passages 134 to transfer heat generated from the power module 120 to the coolant. The power module 120 may be cooled by coolant flowing along the cooling passages 134.

The plurality of cooling fins 133 are formed of an aluminum or aluminum alloy material. The plurality of cooling fins 133 are respectively in contact with both side surfaces of the power module 120. Since the cooling fins 133 have higher thermal conductivity than water, heat generated from the power module 120 may be conducted to the plurality of cooling fins 133 faster than coolant.

The plurality of cooling fins 133 may expand a heat exchange area of the power module 120, thereby improving the cooling performance of the power module 120, and maximizing the cooling efficiency of the power module 120.

The plurality of cooling fins 133 may be made of the same metal material as the cover. Accordingly, the heat of the power module 120 may be transferred to the cover through the cooling fins 133, and may be directly discharged from the cover to an outside of the module housing 110.

Since the plurality of cooling fins 133 are integrally formed on each of the upper cover 130 and the lower cover 131, a separate bonding process is not required. For example, the aluminum cooling fins 133 in the related art must be bonded to the power module 120, and the bonded cooling fins may be corroded by being in contact with coolant, thereby causing the separation/peeling of the cooling fins 133 due to weakening of a bonding strength of the cooling fins 133. However, an integral structure of the cooling fins 133 according to the present disclosure may solve the foregoing problems in the related art.

The plurality of cooling fins 133 may be integrally formed on a cover of the power module assembly 100 prior to manufacturing the cover, thereby simplifying an entire assembly process of the power module assembly 100. On the contrary, the structure of the cooling fins 133 in the related art has a structure in which the cooling fins are ribbon-bonded to the power module 120, and thus an additional process and an inspection process may be required, thereby increasing the number of processes and complicating the manufacturing process.

The plurality of cooling fins 133 may be disposed to overlap with the power module 120 in a top-down direction, and disposed at equal intervals in horizontal and vertical directions of the cover, thereby uniformly distributing the heat of the power module 120.

The plurality of cooling fins 133 may be arranged in a plurality of rows in horizontal and vertical directions in the cooling passage 134, and the cooling fins 133 in odd rows and the cooling fins 133 in even rows may be alternately arranged to each other, thereby allowing coolant that has passed through a passage between the cooling fines 133 in odd rows to collide with the next cooling fins 133 in even rows so as to improve heat transfer performance and heat exchange efficiency between the coolant and the cooling fins 133.

The plurality of cooling fins 133 may be defined in a circular cross-sectional shape. Accordingly, even when the flow of coolant flowing along the cooling passage 134 collides with the plurality of cooling fins 133, a resistance of the cooling fins 133 may be minimized.

The plurality of cooling fins 133 may be defined in a conical shape. One end of the cooling fin 133 may be in contact with the power module 120 in a flat shape, and the other end of the cooling fin 133 may be integrally connected to the cover. The cooling fin 133 may be defined to be inclined in a larger diameter from one end to the other end thereof. The inclined side structure of the cooling fins 133 may increase a supporting force of the cover. In addition, as a contact area between the coolant and the cooling fin 133 increases from one end of the cooling fin 133 to the other end thereof, heat generated from the power module 120 may move from one end of the cooling fin 133 to the other end thereof to be in contact with the coolant in an extended area, thereby improving cooling efficiency.

The structure of the plurality of cooling fins 133 defining the cooling passage 134 may be applied to the upper cover 130 and the lower cover 131 without concentrating on the power module, thereby maximizing the heat dissipation effect.

## Claims

1. A power module assembly (100), comprising:
a module housing (110) having a power module (120) for power conversion;
an upper cover (130) mounted to cover an upper portion of the module housing (110) with the power module (120) interposed therebetween;
a lower cover (131) mounted to cover a lower portion of the module housing (110) with the power module (120) interposed therebetween;
a plurality of first cooling fins (1331) protruding from an inner side of the upper cover (130) toward one side surface of the power module (120) to define a first cooling passage (1341) at an inner side of the upper cover (130); and
a plurality of second cooling fins (1332) protruding from an inner side of the lower cover (131) toward the other side surface of the power module (120) to define a second cooling passage (1342) at an inner side of the lower cover (131).

2. The power module assembly (100) of claim 1, wherein each of the plurality of first cooling fins (1331) and the plurality of second cooling fins (1332) is in contact with the power module (120) to expand a heat exchange area between coolant flowing through the first cooling passage (1341) and the second cooling passage (1342) and the power module (120).

3. The power module assembly (100) of claim 1 or 2, wherein a protruding end portion of each of the plurality of first cooling fins (1331) and the plurality of second cooling fins (1332) is defined in a flat shape.

4. The power module assembly (100) of any one of claims 1 through 3, wherein each of the plurality of first cooling fins (1331) and the plurality of second cooling fins (1332) is defined in a circular cross-sectional shape.

5. The power module assembly (100) of any one of claims 1 through 4, wherein each of the plurality of first cooling fins (1331) and the plurality of second cooling fins (1332) is defined to have a diameter gradually decreasing from an inner surface of each of the upper cover (130) and the lower cover (131) toward the power module (120).

6. The power module assembly (100) of any one of claims 1 through 5, wherein a plurality of the power modules (120) are arranged in parallel on a same plane, and
each of the plurality of first cooling fins (1331) and the plurality of second cooling fins (1332) have the same protruding length.

7. The power module assembly (100) of any one of claims 1 through 6, wherein a plurality of the power modules (120) are arranged to be spaced apart in a length direction in the module housing (110),
the plurality of first cooling fins (1331) and the plurality of second cooling fins (1332) are arranged to be spaced apart in a first and a second direction, the first direction being orthogonal to the second direction, and
the plurality of first cooling fins (1331) and the plurality of second cooling fins (1332) each constitute a group to overlap with the power module (120) in a third direction, the third direction being orthogonal to the first direction and being orthogonal to the second direction, and a plurality of first cooling fin groups and a plurality of second cooling fin groups are arranged with a larger distance than that between the plurality of first cooling fins (1331) or between the plurality of second cooling fins (1332).

8. The power module assembly (100) of any one of claims 1 through 7, wherein the plurality of first cooling fins (1331) or the plurality of second cooling fins (1332) are arranged in a plurality of rows in in a first and a second direction, the first direction being orthogonal to the second direction, and among the plurality of rows, odd and even rows are alternately arranged to each other at equal intervals.

9. The power module assembly (100) of any one of claims 1 through 8, wherein the power module (120) is received inside the module housing (110), and
a heating surface of the power module (120) is exposed to the first cooling passage (1341) and the second cooling passage (1342) through an opening portion disposed to pass through the module housing (110) in a top-down direction.

10. The power module assembly (100) of any one of claims 1 through 9, wherein a plurality of the power modules (120) are received inside the module housing (110) to be spaced apart, and
the module housing (110) comprises:
a plurality of receiving portions arranged to pass therethrough in a third direction, the third direction being orthogonal to a first direction and being orthogonal to a second direction, to expose a heating surface of the power module (120), and arranged to pass therethrough in a lateral direction to protrude a plurality of terminals provided on both side surfaces of the power module (120), respectively, so as to receive each of the plurality of power modules (120); and
a plurality of communication holes arranged to pass therethrough in a top-down direction to communicate between the first cooling passage (1341) and the second cooling passage (1342).

11. The power module assembly (100) of any one of claims 1 through 10, comprising:
a plurality of recess portions arranged to face each other on both side surfaces of the module housing (110), respectively, and defined to be concave along a circumference of the module housing (110); and
a plurality of fastening protrusions arranged to protrude from an inner surface of each of the upper cover (130) and the lower cover (131) so as to be fitted to both sides of the recess portion, and spaced apart in a direction crossing both sidewalls of the recess portion with the plurality of first cooling fins (1331) interposed therebetween.

12. The power module assembly (100) of any one of claims 1 through 11, comprising:
a coolant inlet port provided at one side of the upper cover (130), and disposed to communicate with the first cooling passage (1341); and
a coolant outlet port provided at the other side of the upper cover (130), and disposed to communicate with the first cooling passage (1341).

13. The power module assembly (100) of any one of claims 1 through 11, comprising:
a coolant inlet port provided at one side of the upper cover (130), and disposed to communicate with the first cooling passage (1341); and
a coolant outlet port provided at the other side of the lower cover (131), and disposed to communicate with the second cooling passage (1342).

14. The power module assembly (100) of any one of claims 1 through 11, comprising:
a plurality of coolant inlet ports provided at one side of the module housing (110), and arranged to communicate with one side of each of the first cooling passage (1341) and the second cooling passage (1342); and
a plurality of coolant outlet ports provided at the other side of the module housing (110), and arranged to communicate with the other side of each of the first cooling passage (1341) and the second cooling passage (1342).

15. The power module assembly (100) of any one of claims 1 through 14, wherein the first cooling fins (1331) and the second cooling fins (1332) are formed to comprise aluminum or an aluminum alloy, and are integrally formed on the upper cover (130) and the lower cover (131), respectively.
